# EUROPEAN PATENT SPECIFICATION

(11) **EP 3 888 140 B1**
(45) Date of publication and mention of the grant of the patent: **24.08.2022**
(21) Application number: 19805254.0
(22) Date of filing: 14.11.2019
(51) Int. Cl.: H01L 33/56, H01L 33/54

(54) **LIGHT-EMITTING DEVICE AND METHOD OF PACKAGING THE SAME**
LICHTEMITTIERENDE VORRICHTUNG UND VERFAHREN ZU VERPACKUNG DAVON
DISPOSITIF ÉLECTROLUMINESCENT ET SON PROCÉDÉ DE CONDITIONNEMENT

(30) Priority: 29.11.2018 WO PCT/CN2018/118103; 21.12.2018 EP 18215443
(43) Date of publication of application: 06.10.2021
(73) Proprietor: Lumileds LLC, San Jose, CA 95131 (US)
(72) Inventor: PAN, Hui Ling, 52068 Aachen (DE); YEW, Hua Sin, 52068 Aachen (DE); YAN, Xinping, 52068 Aachen (DE)
(74) Representative: dompatent von Kreisler Selting Werner - Partnerschaft von Patent- und Rechtsanwälten mbB
(86) International application number: PCT/EP2019/081365
(87) International publication number: WO 2020/109023

(56) References cited:
- EP-A2- 1 249 875
- US-A1- 2009 108 282

## Description

### FIELD OF THE INVENTION

The invention relates to a wire-bonded product, and in particular to a light-emitting device and a method of packaging such a light-emitting device.

### BACKGROUND

Wire bonding is common in the electronic industry to provide a chip with an electrical connection to an outer circuitry. Commonly, a thin wire connects between the electronic chip and a metal lead frame to make the electrical connection.

For optical equipment, such as a light-emitting diode, normally a clear resin without any filler is used to package the chip due to its efficiency in light transmittance. However, the clear resin such as epoxy without fillers becomes hard and brittle after being cured. When the packaged chip is exposed to thermal attacks, the coefficient of thermal expansion (CTE) difference between the metal and the resin will cause pull/push stress onto the bonded wire. This impact becomes higher when the optics resin becomes harder.

US 6,710,377 B2 discloses a light-emitting device including a semiconductor light-emitting element and a silicone resin provided to embed the semiconductor light-emitting element. The use of a silicone resin as the resin for sealing the semiconductor light-emitting elements instead of conventional epoxy resins can reduce the possibility of breakage of the wire.

EP 1249875 A2 and US 2009/108282 A1 relate to a light emitting device comprising a light emitting diode die connected to a lead frame via wire bonding and covered with a first and second resins.

### SUMMARY

In spite of the capability of resisting to wire breakage in the existing devices, there is still a need for a light-emitting device with improved optical properties and/or mechanical strength.

According to an aspect of the invention, there is provided a light-emitting device comprising: a lead frame comprising a die paddle and a lead spaced apart from each other; a light-emitting die attached on the die paddle; a wire bonding the light-emitting die to the lead, wherein a first end of the wire and a region of the light-emitting die to which the first end of the wire is bonded form a first necking area; a first resin cover covering only the first necking area; and a second resin cover directly covering the first resin cover, the light-emitting die, and the wire, wherein the first resin cover has a hardness lower than a hardness of the second resin cover.

By covering only the necking area instead of the whole die and the wire using the first resin, it is expected to improve the optical properties of the device while still providing desired mechanical strength. On one hand, the first (softer) resin such as silicone will provide buffer for mechanical deformation during the thermal attack, thus protecting the wire from harsh stress that easily leads to breakage. The mechanical strength may be even improved in the sense that a smaller stress will be produced due to a smaller interface between the first (softer) resin and the second (harder) resin as compared to the case where the soft resin covers the whole die and the wire and the hard resin then covers the soft resin. On the other hand, covering only the necking area with the first softer resin means that most of the light emitting area of the die remains uncovered by the soft resin. By this, most of the light leaving the light-emitting die directly enters the second resin without having first to pass the first resin. Such has at least two advantages: 1) with the hard resin generally having superior optical properties over the soft resin, in particular a better transparency, less light is absorbed; and 2) with diminishing the boundary between soft and hard resins less light has to pass such boundary and losses by absorption and refraction on such passing are reduced. As a result, the optical properties of the light-emitting device can be improved, e.g., more light can be coupled out from the light-emitting die.

In some embodiments, a second end of the wire and a region of the lead to which the second end of the wire is bonded form a second necking area. In this case, the light-emitting device may further comprise another first resin cover which covers the second necking area, and the second resin cover may further cover the another first resin cover. This provides improved reliability by reducing the risk of breakage at the second end of the wire.

In some embodiments, the first resin cover(s) is/are made of a silicone resin. In some embodiments, the silicone resin has a dynamic viscosity in a range of 1 to 8 Pa·s before cured. Preferably, the silicone resin can cure under room temperature. In some embodiments, the first resin after cured may have a hardness in a range of 30A to 70D (measured as indentation hardness on the durometer in Shore hardness scales A and D).

In some embodiments, the second resin cover is made of an epoxy resin. The term epoxy as used herein is a colloquial name for the epoxide functional group. Epoxy resins, also known as polyepoxides, are a class of reactive prepolymers and polymers which contain epoxide groups.

In some embodiments, the light-emitting die is a light-emitting diode (LED) die. As used herein for purposes of the present invention, the term "LED" should be understood to include any electroluminescent diode or other type of carrier injection/junction-based system that is capable of generating radiation in response to an electric signal. Thus, the term LED includes, but is not limited to, various semiconductor-based structures that emit light in response to current, light emitting polymers, organic light emitting diodes (OLEDs), electroluminescent strips, and the like. In particular, the term LED refers to light-emitting diodes of all types (including semiconductor and organic light-emitting diodes) that may be configured to generate radiation in one or more of the infrared spectrum, ultraviolet spectrum, and various portions of the visible spectrum (generally including radiation wavelengths from approximately 400 nanometers to approximately 700 nanometers).

According to another aspect of the invention, there is provided a method of packaging a light-emitting device. The light-emitting device comprises a lead frame and a light-emitting die, the lead frame comprising a die paddle and a lead spaced apart from each other, the light-emitting die being attached on the die paddle. The method comprises: bonding the light-emitting die to the lead with a wire, wherein a first end of the wire and a region of the light-emitting die to which the first end of the wire is bonded form a first necking area; covering only the first necking area with a first resin cover; and forming a second resin cover directly on and to seal the first resin cover, the light-emitting die, and the wire, wherein the first resin cover has a hardness lower than a hardness of the second resin cover.

These and other aspects of the present invention will be apparent from and elucidated with reference to the embodiment(s) described hereinafter.

### BRIEF DESCRIPTION OF THE DRAWINGS

Further details, features and advantages of the invention are disclosed in the following description of exemplary embodiments in connection with the accompanying drawings, in which:
- Fig. 1: is a schematic cross-sectional view of a light-emitting device according to an embodiment of the present invention;
- Fig. 2: is a schematic cross-sectional view of a light-emitting device according to another embodiment of the present invention; and
- Fig. 3: is a flow chart showing a method of packaging a light-emitting device according to an embodiment of the present invention.

The drawings are not necessarily drawn to scale. Like reference signs refer to like elements throughout.

### DETAILED DESCRIPTION

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another. Thus, a first element, component, region, layer or section discussed below could be termed a second element, component, region, layer or section without departing from the teachings of the present invention.

Spatially relative terms, such as "beneath", "below", "lower", "under", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" or "under" other elements or features would then be oriented "above" the other elements or features. Thus, the exemplary terms "below" and "under" can encompass both an orientation of above and below. Terms such as "before" or "preceding" and "after" or "followed by" may be similarly used, for example, to indicate an order in which light passes through the elements. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

It will be understood that when an element or layer is referred to as being "on", "connected to", "coupled to", or "adjacent to" another element or layer, it can be directly on, connected, coupled, or adjacent to the other element or layer, or intervening elements or layers may be present. In contrast, when an element is referred to as being "directly on," "directly connected to", "directly coupled to", or "immediately adjacent to" another element or layer, there are no intervening elements or layers present. In no event, however, should "on" or "directly on" be construed as requiring a layer to completely cover an underlying layer.

Embodiments of the invention are described herein with reference to schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Accordingly, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and/or the present specification and will not be interpreted in an idealized or overly formal sense unless expressly so defined herein.

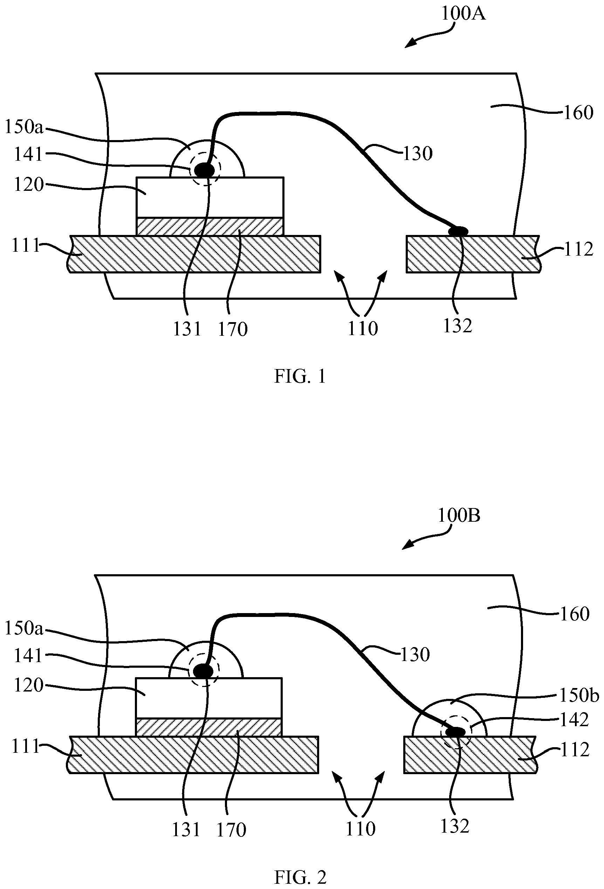

Fig. 1 shows a schematic cross-sectional view of a light-emitting device 100A according to an embodiment of the present invention.

The light-emitting device 100A includes a lead frame 110, a light-emitting die 120, a wire 130, a first resin cover 150a, and a second resin cover 160.

The lead frame 110 includes a die paddle 111 on which the light-emitting die 120 is attached, and a lead 112 spaced apart from the die paddle 111. The die paddle 111 provides mechanical support and additionally heat dissipation for the light-emitting die 120. The lead 112, besides possible further leads, allows the light-emitting die 120 to have an access to an outside circuitry, for example, a power supply.

The light-emitting die 120 is attached by an adhesive 170 such as silver (Ag) paste onto the die paddle 111. The light-emitting die 120 such as an LED die may have an electrode (not shown) on its surface, which is connected with the lead 112 by the bonding wire 130 such as a gold (Au) wire, with a first end 131 of the wire 130 being connected to the electrode of the light-emitting die 120 and a second end 132 of the wire 130 being connected to the lead 112.

As shown in Fig. 1, the first end 131 of the wire 130 and a region of the light-emitting die 120 to which the first end 131 of the wire 130 is bonded form a first necking area 141, which, in practice, is especially prone to breakage due to the CTE difference between the metal electrode and the sealing resin. In this embodiment, a first resin cover 150a is provided to cover only the first necking area 141, and a second resin cover 160 is provided to directly cover the first resin cover 150a, the light-emitting die 120, and the wire 130. The first resin cover 150a is made of, for example, a silicone resin and is softer than the second resin cover 160. In some embodiments, the first resin cover 150a has a hardness in the range of 30A to 70D (measured as indentation hardness on the durometer in Shore hardness scales A and D), and the second resin cover 160 has a hardness higher than that of the first resin cover 150a. Thus, the first resin cover 150a can provide buffer for mechanical deformation during thermal attacks. The second resin cover 160 is made of, for example, an epoxy resin and hence provides superior optical properties (e.g., a higher transmissivity) than the first resin cover 150a. Advantageously, the configuration of the first and second resin covers 150a, 160 provides a tradeoff between the mechanical strength and the optical properties.

Fig. 2 shows a schematic cross-sectional view of a light-emitting device 100B according to another embodiment of the present invention. The same configuration as that of the light-emitting device 100A described above with respect to Fig. 1 is not repeated here for conciseness.

As shown in Fig. 2, the second end 132 of the wire 130 and a region of the lead 112 to which the second end 132 of the wire 130 is bonded form a second necking area 142, which also tends to suffer breakage due to the CTE difference between the metal lead 112 and the sealing resin 160. In this embodiment, another first resin cover 150b, made of the same silicone resin as the first resin cover 150a for example, is provided to cover the second necking area 142, and the second resin cover 160 further covers the another first resin cover 150b accordingly. This further reduces the risk of breakage at the second end 132 of the wire 130, thus resulting in an improved reliability of the light-emitting device 100B.

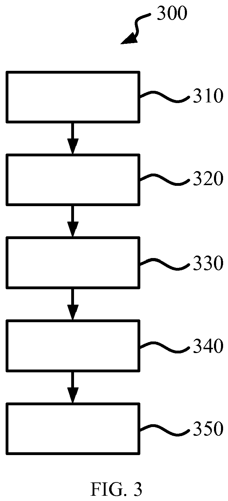

Fig. 3 is a flow chart showing a method 300 of packaging a light-emitting device according to an embodiment of the present invention. The method 300 can be used to package the light-emitting device 100A and/or the light-emitting device 100B and is described below with further reference to Figs. 1 and 2.

At step 310, the light-emitting die 120 is attached to the die paddle 111 of the lead frame 110. Specifically, the die paddle 111 is applied with an adhesive 170 such as silver (Ag) paste and the die 120 is then bonded on the die paddle 111 by means of the silver paste.

At step 320, the silver paste is cured. This can be done for example in a nitrogen (N₂) atmosphere at 175 °C for an hour.

At step 330, the light-emitting die 120 is wire-bonded to the lead 112 with the wire 130. This can be done by a typical wire-bonding process used in the integrated circuit industry. As a result, the first necking area 141 is formed by the first end 131 of the wire 130 and a region of the light-emitting die 120 to which the first end 131 of the wire 130 is bonded, and a second necking area 142 is formed by the second end 132 of the wire 130 and a region of the lead 112 to which the second end 132 of the wire 130 is bonded.

At step 340, the first necking area 141 is covered with a first resin cover 150a. Specifically, a small amount of the first resin such as a silicone resin is dispensed at the first necking area 141 using a dispenser, for example, a needle. The silicone resin may have a dynamic viscosity in the range of, for example, 1 to 8 Pa·s (Pa·s means "Pascal multiplied with seconds") before cured. The amount of the resin dispensed can be controlled by the dispenser such that the resin stays at the location where it was dispensed, forming a hemisphere-like shape without spreading out to smear the whole surface of the light-emitting die 120. In some embodiments, the second necking area 142 is also covered with the first resin cover 150b. This can be done in the same way as the formation of the first resin cover 150a. Then, the first resin dispensed at the first necking area 141 (and potentially the second necking area 142) is cured by a suitable curing process, for example, moistening or heating. In some embodiments, the first resin may be cured by baking in an oven first at 80 °C for two hours and then at 150 °C for three hours. Preferably, the first resin can be chosen such that it can cure under room temperature. Other embodiments are possible as long as the light-emitting die 120 can withstand the curing process used. In some embodiments, the first resin after cured may have a hardness in the range of 30A to 70D (measured as indentation hardness on the durometer in Shore hardness scales A and D).

At step 350, the second resin cover 160 is formed to seal the first resin cover 150a, the light-emitting die 120, and the wire 130. In embodiments where the first resin cover 150b is formed at the second necking area 142, the second resin cover 160 is formed such that it also seals the first resin cover 150b. Step 350 can be done by a typical hard resin shape forming process, for example, molding or casting. As shown in Figs. 1 and 2, the second resin cover 160 wraps around the light-emitting die 120 and the wire 130 (including the first resin covers 150a, 150b).

In embodiments, after step 350, the resultant light-emitting device may be further processed with subsequent processes, such as post-mold-curing (PMC), de-flashing, plating, annealing, etc., which are not described here in detail so as not to obscure the subject matter of the invention.

The invention is defined in the appended claims.

### LIST OF REFERENCE SIGNS:

- 100A, 100B: inventive light emitting devices
- 110: lead frame
- 111: die paddle
- 112: lead
- 120: light-emitting die
- 130: wire
- 131: first wire end
- 132: second wire end
- 141: first necking area
- 142: second necking area
- 150a: first resin cover
- 150b: another first resin cover
- 160: second resin cover
- 170: adhesive
- 300: method of packaging an inventive light-emitting device
- 310: step of attaching light-emitting die 120 to die paddle 111
- 320: step of curing adhesive 170
- 330: step of wire-bonding
- 340: step of covering first necking area with first resin cover
- 350: step of forming second resin cover 160

## Claims

1. A light-emitting device (100A,100B) comprising:
a lead frame (110) comprising a die paddle (111) and a lead (112) spaced apart from each other;
a light-emitting die (120) attached on the die paddle (111);
a wire (130) bonding the light-emitting die (120) to the lead (112), wherein a first end (131) of the wire (130) and a region of the light-emitting die (120) to which the first end (131) of the wire (130) is bonded form a first necking area (141);
a first resin cover (150a) covering only the first necking area (141); and
a second resin cover (160) directly covering the first resin cover (150a), the light-emitting die (120), and the wire (130),
wherein the first resin cover (150a) has a hardness lower than a hardness of the second resin cover (160).

2. The light-emitting device (100B) of claim 1,
wherein a second end (132) of the wire (130) and a region of the lead (112) to which the second end (132) of the wire (130) is bonded form a second necking area (142),
wherein the light-emitting device (100B) further comprises another first resin cover (150b) covering the second necking area (142), and
wherein the second resin cover (160) further covers the another first resin cover (150b).

3. The light-emitting device (100A,100B) of claim 1, wherein the first resin cover (150a) is made of a silicone resin.

4. The light-emitting device (100B) of claim 2, wherein the another first resin cover (150b) is made of a silicone resin.

5. The light-emitting device (100A,100B) of claim 3, wherein the silicone resin has a dynamic viscosity in a range of 1 to 8 Pa·s before cured.

6. The light-emitting device (100A,100B) of claim 3, wherein the silicone resin has a hardness of 30A to 70D in Shore hardness scales after cured.

7. The light-emitting device (100A, 100B) of claim 1, wherein the second resin cover (160) is made of an epoxy resin.

8. The light-emitting device (100A, 100B) of any one of claims 1-7, wherein the light-emitting die (120) is a light-emitting diode die.

9. The light-emitting device (100A, 100B) of any one of claims 1-7, wherein the first resin cover (150a) has a transmissivity lower than a transmissivity of the second resin cover (160).

10. A method (300) of packaging a light-emitting device (100A,100B) , the light-emitting device (100A,100B) comprising a lead frame (110) and a light-emitting die (120), the lead frame (110) comprising a die paddle (111) and a lead (112) spaced apart from each other, the light-emitting die (120) being attached on the die paddle (111), the method (300) comprising:
bonding (330) the light-emitting die (120) to the lead (112) with a wire (130), wherein a first end (131) of the wire (130) and a region of the light-emitting die (120) to which the first end (131) of the wire (130) is bonded form a first necking area (141);
covering (340) only the first necking area (141) with a first resin cover (150a); and
forming (350) a second resin cover (160) directly on and to seal the first resin cover (150a), the light-emitting die (120), and the wire (130), wherein the first resin cover (150a) has a hardness lower than a hardness of the second resin cover (160).

11. The method (300) of claim 10, wherein a second end (132) of the wire (130) and a region of the lead (112) to which the second end (132) of the wire (130) is bonded form a second necking area (142), and wherein the method (300) further comprises covering the second necking area (142) with another first resin cover (150b).

12. The method (300) of claim 10, wherein the covering (340) the first necking area (141) comprises dispensing a silicone resin at the first necking area (141).

13. The method (300) of claim 10, wherein the forming (350) the second resin cover (160) comprises molding or casting an epoxy resin on the first resin cover (150a), the light-emitting die (120), and the wire (130).

14. The method (300) of claim 11, wherein the covering the second necking area (142) comprises dispensing a silicone resin at the second necking area (142).

15. The method (300) of claim 11, wherein the forming (350) the second resin cover (160) comprises molding or casting an epoxy resin on the first resin cover (150a), the another first resin cover (150b), the light-emitting die (120), and the wire (130).

## Patentansprüche

1. Lichtemittierende Vorrichtung (100A, 100B), die aufweist:
einen Leiterrahmen (110), der ein Chippad (111) und eine Leitung (112) aufweist, die voneinander beabstandet sind;
einen lichtemittierenden Chip (120), der an dem Chippad (111) angebracht ist;
einen Draht (130), der den lichtemittierenden Chip (120) mit der Leitung (112) verbindet,
wobei ein erstes Ende (131) des Drahts (130) und ein Bereich des lichtemittierenden Chips (120), an dem das erste Ende (131) des Drahts (130) verbunden ist, einen ersten Einschnürbereich (141) bilden;
eine erste Harzabdeckung (150a), die nur den ersten Einschnürbereich (141) bedeckt; und
eine zweite Harzabdeckung (160), welche die erste Harzabdeckung (150a),
den lichtemittierenden Chip (120), und den Draht (130) direkt bedeckt,
wobei die erste Harzabdeckung (150a) eine Härte aufweist, die geringer ist als eine Härte der zweiten Harzabdeckung (160).

2. Lichtemittierende Vorrichtung (100B) nach Anspruch 1,
wobei ein zweites Ende (132) des Drahts (130) und ein Bereich der Leitung (112), mit dem das zweite Ende (132) des Drahts (130) verbunden ist, einen zweiten Einschnürbereich (142) bilden,
wobei die lichtemittierende Vorrichtung (100B) ferner eine andere erste Harzabdeckung (150b) aufweist, die den zweiten Einschnürbereich (142) bedeckt, und
wobei die zweite Harzabdeckung (160) ferner die andere erste Harzabdeckung (150b) bedeckt.

3. Lichtemittierende Vorrichtung (100A, 100B) nach Anspruch 1, wobei die erste Harzabdeckung (150a) aus einem Silikonharz besteht.

4. Lichtemittierende Vorrichtung (100B) nach Anspruch 2, wobei die andere erste Harzabdeckung (150b) aus einen Silikonharz besteht.

5. Lichtemittierende Vorrichtung (100A, 100B) nach Anspruch 3, wobei das Silikonharz vor dem Aushärten eine dynamische Viskosität in einem Bereich von 1 bis 8 Pa·s aufweist.

6. Lichtemittierende Vorrichtung (100A, 100B) nach Anspruch 3, wobei das Silikonharz nach dem Aushärten eine Härte von 30A bis 70D in Shore-Härteskalen aufweist.

7. Lichtemittierende Vorrichtung (100A, 100B) nach Anspruch 1, wobei die zweite Harzabdeckung (160) aus einem Epoxidharz besteht.

8. Lichtemittierende Vorrichtung (100A, 100B) nach einem der Ansprüche 1-7, wobei der lichtemittierende Chip (120) ein Leuchtdioden-Chip ist.

9. Lichtemittierende Vorrichtung (100A, 100B) nach einem der Ansprüche 1-7, wobei die erste Harzabdeckung (150a) eine Transmissivität aufweist, die geringer ist als eine Transmissivität der zweiten Harzabdeckung (160).

10. Verfahren (300) zum Verpackung einer lichtemittierenden Vorrichtung (100A, 100B), wobei die lichtemittierende Vorrichtung (100A, 100B) einen Leiterrahmen (110) und einen lichtemittierenden Chip (120) aufweist, wobei der Leiterrahmen (110) ein Chippad (111) und eine Leitung (112) aufweist, die voneinander beabstandet sind, wobei der lichtemittierende Chip (120) an dem Chippad (111) angebracht ist, wobei das Verfahren (300) umfasst:
Verbinden (330) des lichtemittierenden Chips (120) mit der Leitung (112) mit einem Draht (130), wobei ein erstes Ende (131) des Drahts (130) und ein Bereich des lichtemittierenden Chips (120), an dem das erste Ende (131) des Drahts (130) verbunden ist, einen ersten Einschnürbereichs (141) bilden;
Bedecken (340) nur des ersten Einschnürbereichs (141) mit einer ersten Harzabdeckung (150a); und
Bilden (350) einer zweiten Harzabdeckung (160) direkt darauf und zum Abdichten der ersten Harzabdeckung (150a), des lichtemittierenden Chips (120), und des Drahts (130), wobei die erste Harzabdeckung (150a) eine Härte aufweist, die geringer ist als eine Härte der zweiten Harzabdeckung (160).

11. Verfahren (300) nach Anspruch 10, wobei ein zweites Ende (132) des Drahts (130) und ein Bereich der Leitung (112), mit dem das zweite Ende (132) des Drahts (130) verbunden ist, einen zweiten Einschnürbereich (142) bilden, und wobei das Verfahren (300) ferner das Bedecken des zweiten Einschnürbereichs (142) mit einer anderen ersten Harzabdeckung (150b) umfasst.

12. Verfahren (300) nach Anspruch 10, wobei das Bedecken (340) des ersten Einschnürbereichs (141) das Auftragen eines Silikonharzes an dem ersten Einschnürbereich (141) umfasst.

13. Verfahren (300) nach Anspruch 10, wobei das Bilden (350) der zweiten Harzabdeckung (160) das Formen oder Gießen eines Epoxidharzes auf der ersten Harzabdeckung (150a), dem lichtemittierenden Chip (120), und dem Draht (130) umfasst.

14. Verfahren (300) nach Anspruch 11, wobei das Bedecken des zweiten Einschnürbereichs (142) das Auftragen eines Silikonharzes an dem zweiten Einschnürbereich (142) umfasst.

15. Verfahren (300) nach Anspruch 11, wobei das Bilden (350) der zweiten Harzabdeckung (160) das Formen oder Gießen eines Epoxidharzes auf der ersten Harzabdeckung (150a), der anderen erste Harzabdeckung (150b), dem lichtemittierenden Chip (120), und dem Draht (130) umfasst.

## Revendications

1. Dispositif électroluminescent (100A, 100B) comprenant :
une grille de connexion (110) comprenant une palette de puce (111) et un conducteur (112) espacés l'un de l'autre ;
une puce électroluminescente (120) fixée sur la palette de puce (111) ;
un fil (130) reliant la puce électroluminescente (120) au conducteur (112), dans lequel une première extrémité (131) du fil (130) et une région de la puce électroluminescente (120) à laquelle la première extrémité (131) du fil (130) est liée forment une première zone de striction (141) ;
un premier couvercle en résine (150a) recouvrant uniquement la première zone de striction (141) ; et
un second couvercle en résine (160) recouvrant directement le premier couvercle en résine (150a), la puce électroluminescente (120) et le fil (130),
dans lequel le premier couvercle en résine (150a) a une dureté inférieure à une dureté du second couvercle en résine (160).

2. Dispositif électroluminescent (100B) selon la revendication 1,
dans lequel une seconde extrémité (132) du fil (130) et une région du conducteur (112) à laquelle la seconde extrémité (132) du fil (130) est liée forment une seconde zone de striction (142),
dans lequel le dispositif électroluminescent (100B) comprend en outre un autre premier couvercle en résine (150b) recouvrant la seconde zone de striction (142), et
dans lequel le second couvercle en résine (160) recouvre en outre l'autre premier couvercle en résine (150b).

3. Dispositif électroluminescent (100A, 100B) selon la revendication 1, dans lequel le premier couvercle en résine (150a) est fait d'une résine de silicone.

4. Dispositif électroluminescent (100B) selon la revendication 2, dans lequel l'autre premier couvercle en résine (150b) est fait d'une résine de silicone.

5. Dispositif électroluminescent (100A, 100B) selon la revendication 3, dans lequel la résine de silicone a une viscosité dynamique dans une plage de 1 à 8 Pa·s avant durcissement.

6. Dispositif électroluminescent (100A, 100B) selon la revendication 3, dans lequel la résine de silicone a une dureté de 30A à 70D sur l'échelle de dureté Shore après durcissement.

7. Dispositif électroluminescent (100A, 100B) selon la revendication 1, dans lequel le second couvercle en résine (160) est fait d'une résine époxy.

8. Dispositif électroluminescent (100A, 100B) selon l'une quelconque des revendications 1 à 7, dans lequel la puce électroluminescente (120) est une puce à diode électroluminescente.

9. Dispositif électroluminescent (100A, 100B) selon l'une quelconque des revendications 1 à 7, dans lequel le premier couvercle en résine (150a) a une transmissivité inférieure à une transmissivité du second couvercle en résine (160).

10. Procédé (300) d'emballage d'un dispositif électroluminescent (100A, 100B), le dispositif électroluminescent (100A, 100B) comprenant une grille de connexion (110) et une puce électroluminescente (120), la grille de connexion (110) comprenant une palette de puce (111) et un conducteur (112) espacés l'un de l'autre, la puce électroluminescente (120) étant fixée sur la palette de puce (111), le procédé (300) comprenant :
la liaison (330) de la puce électroluminescente (120) au conducteur (112) à l'aide d'un fil (130), dans laquelle une première extrémité (131) du fil (130) et une région de la puce électroluminescente (120) à laquelle la première extrémité (131) du fil (130) est liée forment une première zone de striction (141) ;
le recouvrement (340) uniquement de la première zone de striction (141) avec un premier couvercle en résine (150a) ; et
la formation (350) d'un second couvercle en résine (160) directement sur et pour sceller le premier couvercle en résine (150a), la puce électroluminescente (120) et le fil (130), le premier couvercle en résine (150a) ayant une dureté inférieure à une dureté du second couvercle en résine (160).

11. Procédé (300) selon la revendication 10, dans lequel une seconde extrémité (132) du fil (130) et une région du conducteur (112) à laquelle la seconde extrémité (132) du fil (130) est liée forment une seconde zone de striction (142), et dans lequel le procédé (300) comprend en outre le recouvrement de la seconde zone de striction (142) avec un autre premier couvercle en résine (150b).

12. Procédé (300) selon la revendication 10, dans lequel le recouvrement (340) de la première zone de striction (141) comprend la distribution d'une résine de silicone au niveau de la première zone de striction (141).

13. Procédé (300) selon la revendication 10, dans lequel la formation (350) du second couvercle en résine (160) comprend le moulage ou le coulage d'une résine époxy sur le premier couvercle en résine (150a), la puce électroluminescente (120) et le fil (130).

14. Procédé (300) selon la revendication 11, dans lequel le recouvrement de la seconde zone de striction (142) comprend la distribution d'une résine de silicone au niveau de la seconde zone de striction (142).

15. Procédé (300) selon la revendication 11, dans lequel la formation (350) du second couvercle en résine (160) comprend le moulage ou le coulage d'une résine époxy sur le premier couvercle en résine (150a), l'autre premier couvercle en résine (150b), la puce électroluminescente (120) et le fil (130).
